# EUROPEAN PATENT APPLICATION

(11) **EP 1 833 097 A1**
(43) Date of publication of application: **12.09.2007**
(21) Application number: 05819563.7
(22) Date of filing: 26.12.2005
(51) Int. Cl.: H01L 31/04, H01L 21/365

(54) **METHOD FOR FORMING LIGHT ABSORBING LAYER IN CIS-BASED THIN FILM SOLAR BATTERY**

(30) Priority: 28.12.2004 JP 2004378398
(71) Applicant: Showa Shell Sekiyu Kabushiki Kaisha, Minato-ku Tokyo 1358074 (JP)
(72) Inventor: ONODERA, Masaru c/o Showa Shell Sekiyu K.K., Tokyo 135-8074 (JP); KURIYAGAWA, Satoru c/o Showa Shell Sekiyu K.K., Tokyo 135-8074 (JP); TANAKA, Yoshiaki c/o Showa Shell Sekiyu K.K., Tokyo 135-8074 (JP)
(74) Representative: HOFFMANN EITLE
(86) International application number: PCT/JP2005/023791
(87) International publication number: WO 2006/070745

(57) **Abstract**

A simple device is used to make the temperature in an apparatus even and improve the state of being in contact with reactant gases, selenium, and sulfur.

A fan 3 as a device for atmosphere homogenization is disposed in an apparatus, and the work is disposed in the manner which enables a reactant gas to circulate smoothly. Namely, flat platy works 2 are disposed apart from each other at a certain distance parallel to the direction of the major axis of the apparatus while keeping the plates vertical so that the apparatus has passages within the group of works and has gas passages over and under the works and on both sides thereof. Thus, each work is apt to come into contact with the reactant gases in the apparatus and the temperature in the apparatus is even. The state of being in contact with the reactant gases, selenium, and sulfur is improved.

## Description

### TECHNICAL FIELD

The present invention relates to a method for forming the light absorption layer of a CIS type thin-film solar cell.

### BACKGROUND ART

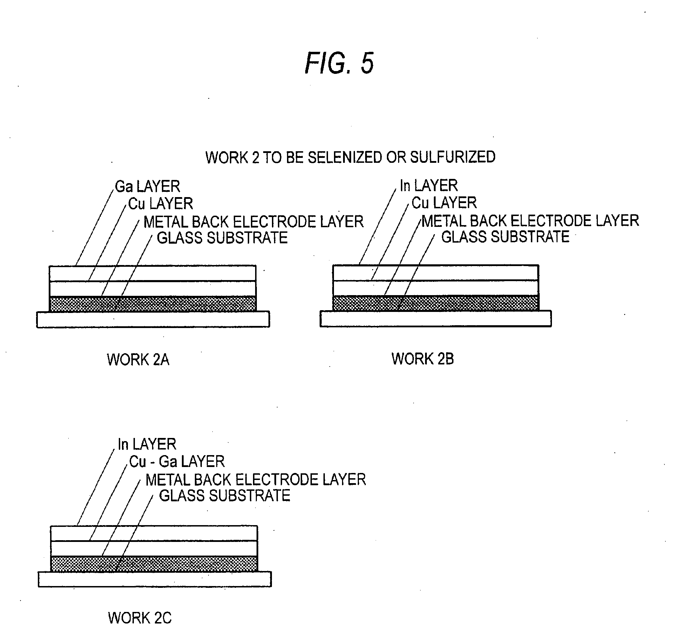

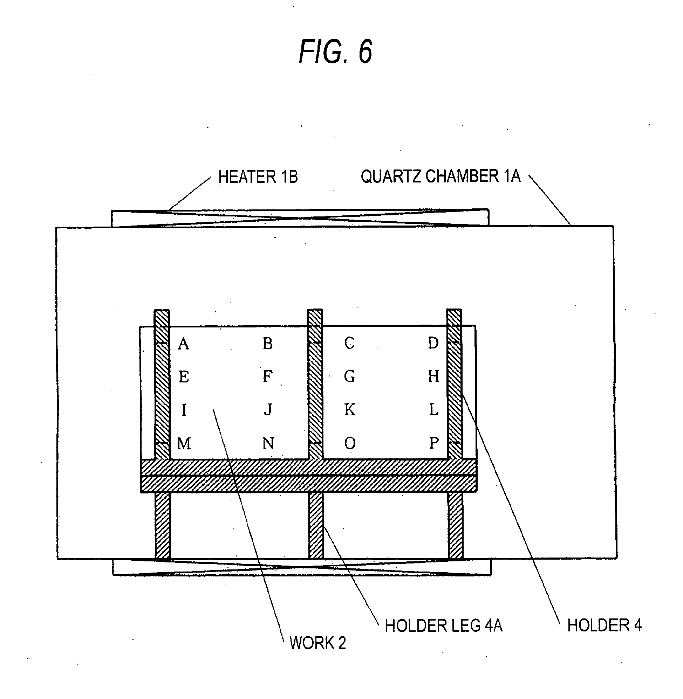

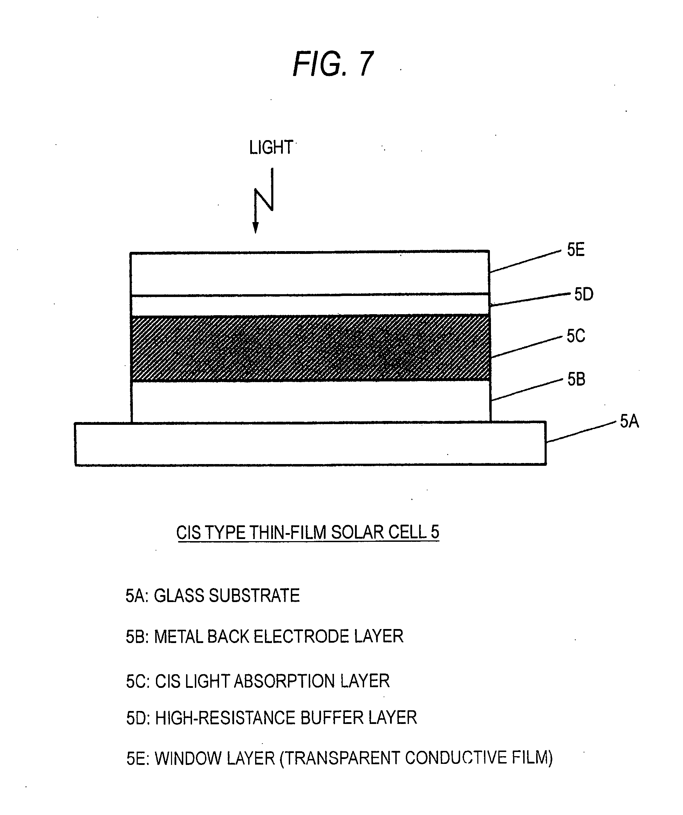

A CIS type thin-film solar cell is a pn heterojunction device having a substrate structure comprising a glass substrate, a metal back electrode layer, a p-type CIS light absorption layer, a high-resistance buffer layer, and an n-type window layer which have been superposed in this order, as shown in Fig. 7. When the CIS light absorption layer is formed, a metallic precursor film of a multilayer structure (hereinafter referred to as work to be treated for film formation) comprising any one of Cu/Ga (work 2A), Cu/In (work 2B), and Cu-Ga/In (work 2C) as shown in Fig. 5 on a metal back electrode layer on a glass substrate is selenized or sulfurized to form the CIS light absorption layer. A method of film formation which has been used for selenizing or sulfurizing the work to be treated for film formation comprises disposing such works in a plate form apart from each other at a certain distance in a cylindrical quartz chamber 1A as shown in Fig. 6 and selenizing or sulfurizing the works based on natural circulation to form light absorption layers.

In the case of conducting selenization, the works (metallic precursor films) are disposed in the apparatus and the atmosphere in the apparatus is replaced with an inert gas, e.g., nitrogen gas. Thereafter, a selenium source is introduced and heated in the state of being enclosed, and the works are held at a certain temperature for a certain time period to thereby form selenide-based CIS light absorption layers.

In the case of conducting sulfurization, the works are disposed in the apparatus and the atmosphere in the apparatus is replaced with an inert gas, e.g., nitrogen gas. Thereafter, a sulfur source, e.g., sulfide gas, is introduced and heated in the state of being enclosed, and the works are held at a certain temperature for a certain time period to thereby form sulfide-based CIS light absorption layers.

Furthermore, in the case of conducting sulfurization after selenization, the selenium atmosphere enclosed in the apparatus is replaced with a sulfur atmosphere. The temperature in the apparatus is elevated while maintaining the sulfur atmosphere and the works are held at a certain temperature for a certain time period to react the works with pyrolytic sulfur and thereby form sulfide/selenide-based CIS light absorption layers.

The related-art method of film formation (selenization or sulfurization apparatus) based on natural circulation shown in Fig. 6 has had the following problems. Since there is a difference in specific gravity between the reactant gas such as H₂Se or H₂S (and chalcogen element (selenium or sulfur)) and a diluent gas (inert gas), the reactant gas is apt to accumulate in a lower part of the reaction furnace and the reactant gas in the furnace becomes uneven. As a result, a light absorption layer in which the proportions of components are uneven is formed, resulting in uneven solar cell performances.
Furthermore, the performances of a solar cell are adversely influenced by any defective part in the work treated for film formation (in the case where given quality or performance is not satisfied) and the presence of such a defective part disadvantageously results in the fabrication of a solar cell which as a whole has poor quality or performances.

A technique for evenly dispersing a reactant gas in the furnace is known which comprises disposing a device for evenly dispersing a reactant gas in the furnace, e.g., a fan for stirring the reactant gas, and baffles serving as circulating passages for the reactant gas in a step for fabricating a plasma display panel or the like (see patent document 1). The application of this furnace is in the burning of a substrate glass for plasma display panels or the like, and the technique is intended to make the temperature in the furnace even. The work in this application differs and no reactant gas is used. Because of this, it is difficult to directly use this technique for the formation of the light absorption layer of a CIS type thin-film solar cell. Moreover, the furnace described in patent document 1, which is a furnace having therein baffles serving as the circulating passages, has a complicated constitution and is expensive. Use of the technique hence has had a problem that production cost increases.

Patent Document 1: JP-A-11-311484

### DISCLOSURE OF THE INVENTION

### PROBLEMS THAT THE INVENTION IS TO SOLVE

The invention has been achieved in order to eliminate the problems described above. An object of the invention is to make the temperature in an apparatus even and improve the state of being in contact with a reactant gas and a chalcogen element (selenium or sulfur) by employing a constitution including (addition of) a simple device and to thereby enable light absorption layers which are simultaneously formed to have even and improved quality (component proportion) and performances and give solar cells with improved performances in improved product yield.

### MEANS FOR SOLVING THE PROBLEMS

(1) The invention, which eliminates the problems described above, provides a method for forming the light absorption layer of a CIS type thin-film solar cell which is a pn heterojunction device having a substrate structure comprising a glass substrate, a metal back electrode layer, a p-type CIS light absorption layer, a high-resistance'buffer layer, and an n-type window layer which have been superposed in this order,
   wherein the formation method comprises any one of:
   a selenization step in which a work to be selenized or sulfurized (hereinafter referred to as works) comprises a glass substrate, a metal back electrode layer formed thereon, and a metallic precursor film of a multilayer structure comprising any one of Cu/Ga, Cu/In, and Cu-Ga/In formed on the metal back electrode layer is selenized to form a selenide-based CIS light absorption layer;
   a sulfurization step in which the work is sulfurized to form a sulfide-based CIS light absorption layer; and
   a selenization/sulfurization step in which the work is selenized/sulfurized to form a sulfide/selenide-based CIS light absorption layer,
   wherein in each step, a device for atmosphere homogenization is disposed in the apparatus and the work is disposed in a manner which enables a reactant gas to circulate smoothly, whereby the temperature in the apparatus is made even and the work is improved in the state of being in contact with the reactant gas and with a chalcogen element (selenium and sulfur).

(2) The invention provides the method for forming the light absorption layer of a CIS type thin-film solar cell as described under (1) above, wherein the device for atmosphere homogenization comprises an electric fan which forcedly circulates the atmospheric gas, and the manner of work disposition is one in which two or more flat platy works (a group of works) are disposed apart from each other at a certain distance in a cylindrical apparatus parallel to the direction of the major axis of the apparatus while keeping the plates vertical, wherein the apparatus has reactant-gas passages within the group of works in the upward/downward direction and in the major-axis direction and further has passages of the gases over and under the group of works and on both sides thereof, and each work is apt to come into contact with the reactant gases present in the apparatus.

(3) The invention provides the method for forming the light absorption layer of a CIS type thin-film solar cell as described under (1) or (2) above, wherein the selenization step comprises introducing the selenium source, heating the selenium source while keeping it in the state of being enclosed, preparing the inside of the apparatus by the device for atmosphere homogenization and manner of work disposition described in (1) or (2) above to enable the work to evenly undergo a seleni zation reaction, and holding the metallic precursor film at a certain temperature for a certain time period to thereby form a selenide-based CIS light absorption layer.

(4) The invention provides the method for forming the light absorption layer of a CIS type thin-film solar cell as described under (1), (2), or (3) above, wherein the selenization step comprises disposing the work in an apparatus, replacing the atmosphere in the apparatus with an inert gas, e. g., nitrogen gas, subsequently introducing at ordinary temperature a selenium source, e.g., hydrogen selenide gas, diluted to a concentration in the range of 1-20%, desirably 2-10%, homogenizing the gas atmosphere which tends to separate into an upper part and a lower part within the apparatus due to a difference in specific gravity between the gases by the device for atmosphere homogenization and manner of work disposition described in (1) or (2) above while keeping the selenium source in the state of being enclosed, heating the gas atmosphere to 400-550°C, desirably 450-500°C, at 10-100 °C/min, and thereafter holding the work at this temperature for a certain time period, i.e., 10-200 minutes, desirably 30-120 minutes, to thereby form a selenide-based CIS light absorption layer.

(5) The invention provides the method for forming the light absorption layer of a CIS type thin-film solar cell as described under (1) or (2) above, wherein the sulfurization step comprises disposing the work in an apparatus, replacing the atmosphere in the apparatus with an inert gas, e.g., nitrogen gas, subsequently introducing at ordinary temperature a sulfur source, e.g., sulfide gas, diluted to a concentration in the range of 1-30%, desirably 2-20%, homogenizing the gas atmosphere which tends to separate into an upper part and a lower part within the apparatus due to a difference in specific gravity between the gases by the device for atmosphere homogenization and manner of work disposition described in (1) or (2) above while keeping the sulfur source in the state of being enclosed, heating the gas atmosphere to 400-550°C, desirably 450-550°C, at 10-100 °C/min, and thereafter holding the work at this temperature for a certain time period, i.e., 10-200 minutes, desirably 30-120 minutes, to thereby form a sulfide-based CIS light absorption layer.

(6) The invention provides the method for forming the light absorption layer of a CIS type thin-film solar cell as described under (1) or (2) above, wherein the selenization/sulfurization step comprises forming the selenide-based CIS light absorption layer described in claim 1, 2, 3, or 4, thereafter replacing the selenium atmosphere enclosed in the apparatus with a sulfur atmosphere, preparing the inside of the apparatus by the device for atmosphere homogenization and manner of work disposition described in (1) or (2) above to enable a sulfurization reaction to proceed evenly while elevating the temperature in the apparatus and maintaining the sulfur atmosphere, and holding the selenide-based CIS light absorption layer described in (1), (2), or (3) above at a certain temperature for a certain time period to react the layer with sulfur and thereby form a sulfide/selenide-based CIS light absorption layer.

(7) The invention provides the method for forming the light absorption layer of a CIS type thin-film solar cell as described under (1), (2), (3), or (4) above, wherein the selenide-based CIS light absorption layer comprises CuInSe₂, Cu (InGa) Se₂, or CuGaSe₂.

(8) The invention provides the method for forming the light absorption layer of a CIS type thin-film solar cell as described under (1), (2), or (5) above, wherein the sulfide-based CIS light absorption layer comprises CuInS₂, Cu(InGa)S₂, or CuGaS₂.

(9) The invention provides the method for forming the light absorption layer of a CIS type thin-film solar cell as described under (1), (2), or (6) above, wherein the sulfide/selenide-based CIS light absorption layer comprises CuInSe₂ having CuIn (SSe)₂ or Cu (InGa) (SSe)₂ or CuGa (SSe)₂ or CuIn (SSe)₂ as a surface layer, Cu (InGa) Se₂ having CuIn (SSe)₂ as a surface layer, Cu (InGa) (SSe)₂ having CuIn (SSe)₂ as a surface layer, CuGaSe₂ having CuIn (SSe)₂ as a surface layer, CuGaSe₂ having CuIn (SSe)₂ as a surface layer, Cu(InGa)Se₂ having Cu (InGa) (SSe)₂ as a surface layer, CuGaSe₂ having Cu (InGa) (SSe)₂ as a surface layer, Cu (InGa) Se₂ having CuGa (SSe)₂ as a surface layer, or CuGaSe₂ having CuGa (SSe)₂ as a surface layer.

### ADVANTAGES OF THE INVENTION

The invention employs an atmosphere-homogenizing device for making the temperature in the apparatus even and for improving the state of being in contact with reactant gases and chalcogen elements (selenium and sulfur) and the manner of work disposition which enables a reactant gas to circulate smoothly. By such simple device and manner, the temperature in the apparatus is made even and the state of being in contact with the reactant gas and a chalcogen element (selenium and sulfur) is improved. Thus, the light absorption layers of CIS type thin-film solar cells which are simultaneously formed can be made to have even and improved quality (component proportion) and performances. In addition, the solar cell performances of CIS type thin-film solar cells and the yield of the products can be improved.

### BEST MODE FOR CARRYING OUT THE INVENTION

The invention provides a method of film formation for use in the step of film formation by selenization, sulfurization/selenization, sulfurization, or selenization/sulfurization among steps for forming the CIS light absorption layer in a CIS type thin-film solar cell. As shown in Fig. 7, a CIS type thin-film solar cell 5 is a pn heterojunction device of a substrate structure comprising a glass substrate 5A, a metal back electrode layer 5B, a p-type CIS light absorption layer 5C, a high-resistance buffer layer 5D, and an n-type window layer (transparent conductive film) 5E which have been superposed in this order. When the CIS light absorption layer 5C is formed, a metallic precursor film of a multilayer structure (hereinafter referred to as work to be treated for film formation) comprising any one of Cu/Ga (work 2A), Cu/In (work 2B), and Cu-Ga/In (work 2C) as shown in Fig. 5 on a metal back electrode layer 5B on a glass substrate is subjected to the step of film formation by selenization, sulfurization, or selenization/sulfurization to form the CIS light absorption layer 5C.

In the film formation method of the invention, forced circulation is employed. Because of this, the invention can eliminate the phenomenon in which a reactant gas such as H₂Se or H₂S (and chalcogen element (selenium or sulfur)) is apt to accumulate in a lower part of the reaction furnace due to a difference in specific gravity between the reactant gas and a diluent gas (inert gas) to cause unevenness in reactant gas concentration in the furnace (see the experimental data for a related-art apparatus given in Table 2) and the phenomenon in which an upper part and lower part of the furnace come to have a temperature difference (see the experimental data for a related-art method of film formation give in Fig. 6) ; these phenomena are problems of the related-art method of film formation employing natural circulation. Thus, the temperature in the apparatus is made even and the state of being in contact with the reactant gas and chalcogen element (selenium or sulfur) is improved. As a result, the light absorption layers of CIS type thin-film solar cells which are simultaneously formed can be made to have even and improved quality (component proportion) and performances. In addition, the solar cell performances of CIS type thin-film solar cells and the yield of the products can be improved.

Accordingly, in the method of film formation of the invention, a device for atmosphere homogenization is disposed in the apparatus for each step in order to homogenize the temperature and reactant gas in the apparatus and to improve the state of being in contact with the reactant gas and chalcogen element (selenium or sulfur). In addition, the manner of work disposition is employed in each step in order to make the circulation of the reactant gas smooth.

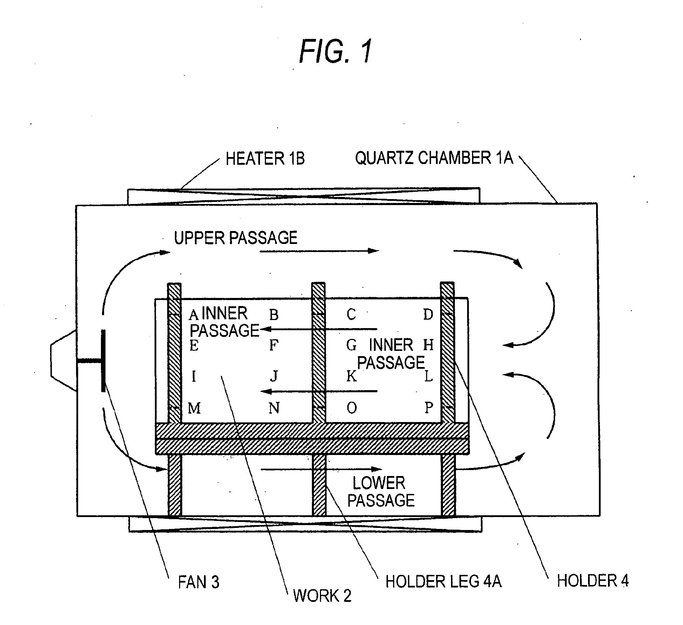

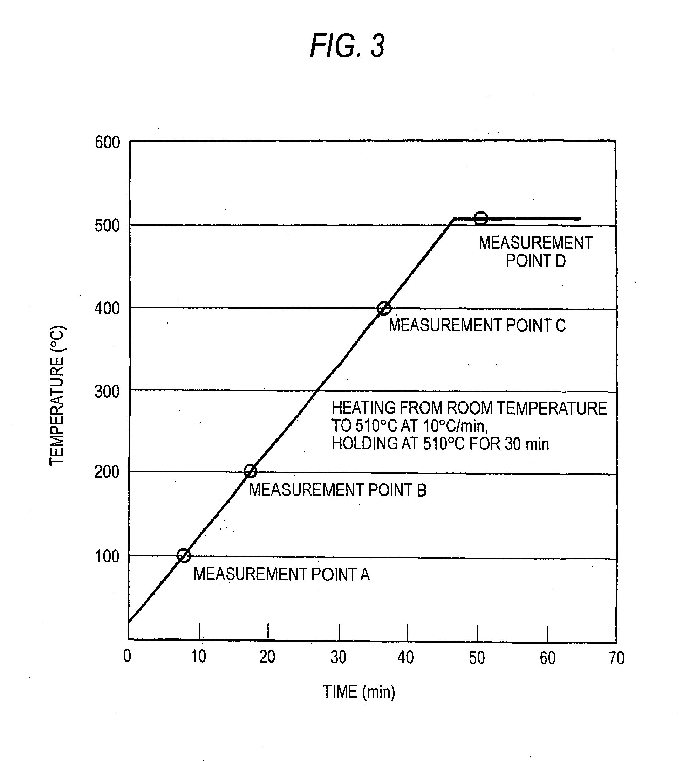

As shown in Figs. 1 and 3, the device for atmosphere homogenization may be an electric fan 3 and the manner of work disposition may be as follows. A holder 4 is used to dispose two or more flat platy works (a group of works) in a cylindrical apparatus (quartz chamber 1A) so that the works 2 are apart from each other at a certain distance and are parallel to the direction of the major axis of the apparatus while keeping the plates vertical, and that the apparatus has inner passages which are reactant-gas passages in the upward/downward direction and the major-axis direction within the group of works and further has an upper passage, a lower passage, and left and right side passages as passages outside the group of works. Furthermore, the device and the manner of disposition enable each work to easily come into contact with the reactant gas present in the apparatus.

The selenization step may comprise introducing the selenium source, heating the selenium source while keeping it in the state of being enclosed, preparing the inside of the apparatus by the device for atmosphere homogenization and manner of work disposition described above to enable the work to evenly undergo a selenization reaction, and holding each metallic precursor film at a certain temperature for a certain time period to thereby form a selenide-based CIS light absorption layer.

The selenization step may comprise disposing the work in the apparatus, replacing the atmosphere in the apparatus with an inert gas, e.g., nitrogen gas, subsequently introducing at ordinary temperature a selenium source, e.g., hydrogen selenide gas, diluted to a concentration in the range of 1-20%, desirably 2-10%, homogenizing the gas atmosphere which tends to separate into an upper part and a lower part within the apparatus due to a difference in specific gravity between the gases by the device for atmosphere homogenization and manner of work disposition described above while keeping the selenium source in the state of being enclosed, heating the gas atmosphere to 400-550°C, desirably 450-500°C, at 10-100 °C/min, and thereafter holding the work at this temperature for a certain time period, i.e., 10-200 minutes, desirably 30-120 minutes, to thereby form a selenide-based CIS light absorption layer.

The selenide-based CIS light absorption layer may comprise CuInSe_{2,} Cu (InGa) Se_{2,} or CuGaSe_{2.}

The sulfurization step may comprise disposing the work in an apparatus, replacing the atmosphere in the apparatus with an inert gas, e.g., nitrogen gas, subsequently introducing at ordinary temperature a sulfur source, e.g., sulfide gas, diluted to a concentration in the range of 1-30%, desirably 2-20%, homogenizing the gas atmosphere which tends to separate into an upper part and a lower part within the apparatus due to a difference in specific gravity between the gases by the device for atmosphere homogenization and manner of work disposition described above while keeping the sulfur source in the state of being enclosed, heating the gas atmosphere to 400-550°C, desirably 450-550°C, at 10-100 °C/min, and thereafter holding the work at this temperature for a certain time period, i.e., 10-200 minutes, desirably 30-120 minutes, to thereby form a sulfide-based CIS light absorption layer.

The sulfide-based CIS light absorption layer may comprise CuInS₂, Cu(InGa)S₂, or CuGaS₂.

The selenization/sulfurization step may comprise forming the selenide-based CIS light absorption layer described above, thereafter replacing the selenium atmosphere enclosed in the apparatus with a sulfur atmosphere, preparing the inside of the apparatus by the device for atmosphere homogenization described above to enable a sulfurization reaction to proceed evenly while elevating the temperature in the apparatus and maintaining the sulfur atmosphere, and holding the selenide-based CIS light absorption layer at a certain temperature for a certain time period to react the layer with sulfur and thereby form a sulfide/selenide-based CIS light absorption layer.

The sulfide/selenide-based CIS light absorption layer may comprise CuInSe₂ having CuIn(SSe)₂ or Cu(InGa)(SSe)₂ or CuGa (SSe)₂ or CuIn (SSe)₂ as a surface layer, Cu (InGa) Se₂ having CuIn (SSe)₂ as a surface layer, Cu (InGa) (SSe)₂ having CuIn (SSe)₂ as a surface layer, CuGaSe₂ having CuIn (SSe)₂ as a surface layer, CuGaSe₂ having CuIn (SSe) ₂ as a surface layer, Cu (InGa) Se₂ having Cu (InGa) (SSe)₂ as a surface layer, CuGaSe₂ having Cu (InGa) (SSe)₂ as a surface layer, Cu (InGa) Se₂ having CuGa (SSe) ₂ as a surface layer, or CuGaSe₂ having CuGa(SSe)₂ as a surface layer.

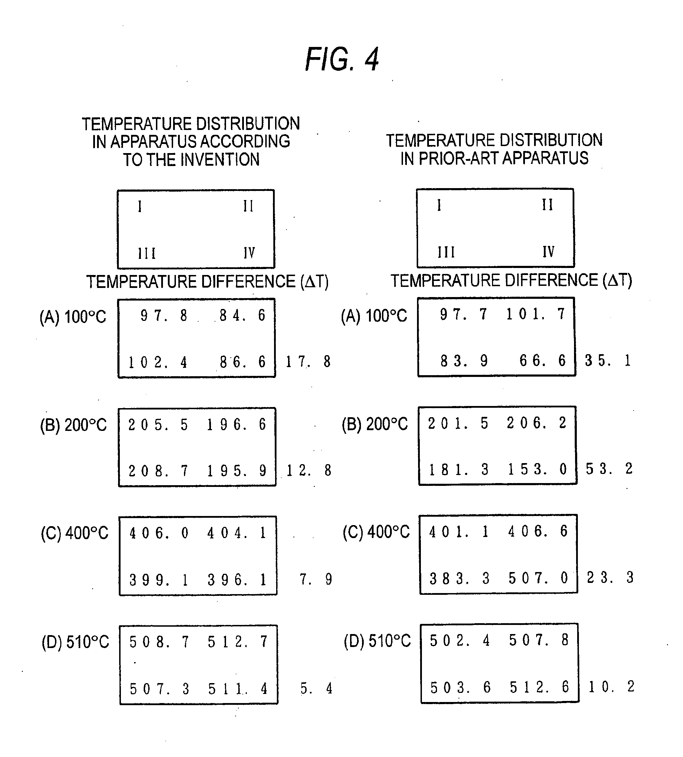

Fig. 4 shows a comparison between temperature distributions in a work (substrate size: 300 mm x 1,200 mm) in the method of film formation of the invention, which employs the forced circulation, and temperature distributions in a work (substrate size: same as in the invention) in the related-art method of film formation employing natural circulation. In each method of film formation, a filmwas formed while regulating the temperature in the manner shown in Fig. 3 (heating from room temperature to 510°C at 10 °C/min and holding at 510°C for 30 minutes). A thermocouple was attached to each of four sites I, II, III, and IV on the work, and this work was heated according to the temperature program. A temperature distribution was determined at each of measurement point A (100°C),measurementpointB (200°C), measurementpointC (400°C), and measurement point D (510°C), and the results thereof are shown. As a result, the method of film formation of the invention was found to have smaller temperature differences in the work at each measurement point than the related-art method of film formation.

A CIS type thin-film solar cell (size: 300 mm x 1,200 mm) having a CIS light absorption layer formed by the method of film formation of the invention, which employs the forced circulation, was divided into sixteen pieces (A to P), and each piece was examined for conversion efficiency. The results thereof are shown in Table 1 below (the conversion efficiencies respectively corresponding to the measurement areas A to P are shown).

**[Table 1]**

| Apparatus according to the invention: measurement sites on work (selenization or sulfurization) | | | |
|---|---|---|---|
| A | B | C | D |
| E | F | G | H |
| I | J | K | L |
| M | N | O | P |

| Results of conversion efficiency (Eff (%)) measurement | | | |
|---|---|---|---|
| 11.9 | 11.9 | 11.7 | 12.1 |
| 11.9 | 11.5 | 12.3 | 11.6 |
| 12.2 | 12.4 | 12.5 | 11.8 |
| 12.0 | 12.3 | 12.0 | 12.1 |

A CIS type thin-film solar cell (size: 300 mm x 1,200 mm) having a CIS light absorption layer formed by the related-art method of film formation employing natural circulation was divided into sixteen pieces (A to P), and each piece was examined for conversion efficiency. The results thereof are shown in Table 2 below (the conversion efficiencies respectively corresponding to the measurement areas A to P are shown).

**[Table 2]**

| Related-art apparatus: measurement sites on work (selenization or sulfurization) | | | |
|---|---|---|---|
| A | B | C | D |
| E | F | G | H |
| I | J | K | L |
| M | N | O | P |

| Results of conversion efficiency (Eff (%)) measurement | | | |
|---|---|---|---|
| 9.6 | 9.5 | 9.4 | 9.5 |
| 9.6 | 9.7 | 10.1 | 9.9 |
| 11.0 | 10.5 | 10.7 | 11.5 |
| 11.9 | 11.5 | 11.6 | 12.0 |

As shown in Table 1 and Table 2, it was found that the CIS type thin-film solar cell produced using the method of film formation of the invention has higher conversion efficiencies than the CIS type thin-film solar cell produced using the related-art method of film formation and that the former solar cell has an almost even conversion efficiency throughout the areas.
Incidentally, the conversion efficiencies were determined through a measurement made with a constant-light solar simulator under standard conditions (irradiation intensity, 100 mW/cm²; AM (air mass), 1.5; temperature, 25°C) in accordance with JIS C 8914I.

As described above, the method of film formation of the invention proved to enable a work to have an even temperature distribution throughout the sites therein as shown in Fig. 3 and give a solar cell having an even and high conversion efficiency throughout the sites therein as shown in Table 1.

### BRIEF DESCRIPTION OF THE DRAWINGS

[Fig. 1] Fig. 1 is a diagrammatic view (front view) showing the constitution of a film formation apparatus for use in the method of the invention for forming the light absorption layer of a CIS type thin-film solar cell.

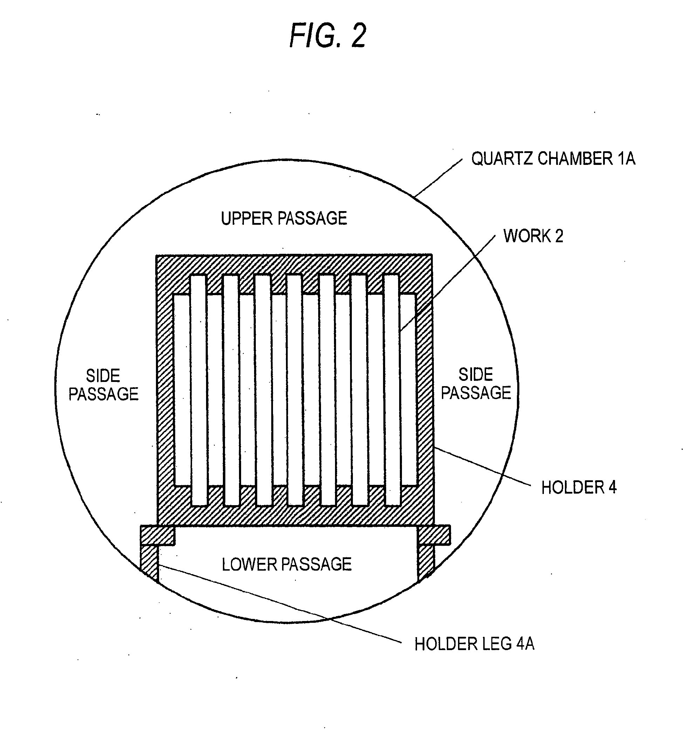

[Fig. 2] Fig. 2 is a view (side view) showing works to be treated for film formation which have been disposed in the apparatus for forming the light absorption layer of a CIS type thin-film solar cell according to the invention.
[Fig. 3] Fig. 3 is a diagram showing temperature regulation (including measurement points for determining the temperature distributions shown in Fig. 5) in the method of film formation of the invention.
[Fig. 4] Fig. 4 is diagrams showing a comparison between temperature distributions of a work treated for film formation in an apparatus for forming the light absorption layer of a CIS type thin-film solar cell according to the invention and temperature distributions of a work treated for film formation in an apparatus for forming the light absorption layer of a CIS type thin-film solar cell according to a related-art technique, with respect to each measurement point.
[Fig. 5] Fig. 5 is views (sectional views) showing the constitutions of works to be treated for film formation in the method of the invention for forming the light absorption layer of a CIS type thin-film solar cell.
[Fig. 6] Fig. 6 is a diagrammatic view (front view) showing the constitution of a film formation apparatus for use in a related-art method for forming the light absorption layer of a CIS type thin-film solar cell.
[Fig. 7] Fig. 7 is a diagrammatic view (sectional view) showing the constitution of a CIS type thin-film solar cell.

### DESCRIPTION OF REFERENCE NUMERALS AND SIGNS

- 1: apparatus for film formation
- 1A: quartz chamber
- 1B: heater
- 2: work to be treated for film formation
- 2A: Cu-Ga multilayered film
- 2B: Cu-In multilayered film
- 2C: Cu-Ga-In multilayered film
- 3: fan
- 4: holder
- 4A: holder leg
- 5: CIS type thin-film solar cell
- 5A: glass substrate
- 5B: metal back electrode layer
- 5C: CIS light absorption layer
- 5D: high-resistance buffer layer
- 5E: window layer (transparent conductive film)

## Claims

1. A method for forming the light absorption layer of a CIS type thin-film solar cell which is a pn heterojunction device having a substrate structure comprising a glass substrate, a metal back electrode layer, a p-type CIS light absorption layer, a high-resistance buffer layer, and an n-type window layer which have been superposed in this order,
wherein the formation method comprises any one of:
a selenization step in which a work to be selenized or sulfurized (hereinafter referred to as works) comprises a glass substrate, a metal back electrode layer formed thereon, and a metallic precursor film of a multilayer structure comprising any one of Cu/Ga, Cu/In, and Cu-Ga/In formed on the metal back electrode layer is selenized to form a selenide-based CIS light absorption layer;
a sulfurization step in which the work is sulfurized to form a sulfide-based CIS light absorption layer; and
a selenization/sulfurization step in which the work is selenized/sulfurized to form a sulfide/selenide-based CIS light absorption layer,
wherein in each step, a device for atmosphere homogenization is disposed in the apparatus and the work is disposed in a manner which enables a reactant gas to circulate smoothly, whereby the temperature in the apparatus is made even and the work is improved in the state of being in contact with the reactant gas and with a chalcogen element (selenium and sulfur).

2. The method for forming the light absorption layer of a CIS type thin-film solar cell according to claim 1, wherein the device for atmosphere homogenization comprises an electric fan which forcedly circulates the atmospheric gas, and the manner of work disposition is one in which two or more flat platy works (a group of works) are disposed apart from each other at a certain distance in a cylindrical apparatus parallel to the direction of the major axis of the apparatus while keeping the plates vertical, wherein the apparatus has reactant-gas passages within the group of works in the upward/downward direction and in the major-axis direction and further has passages of the gases over and under the group of works and on both sides thereof, and each work is apt to come into contact with the reactant gases present in the apparatus.

3. The method for forming the light absorption layer of a CIS type thin-film solar cell according to claim 1 or 2, wherein the selenization step comprises introducing the selenium source, heating the selenium source while keeping it in the state of being enclosed, preparing the inside of the apparatus by the device for atmosphere homogenization and manner of work disposition described in claim 1 or 2 to enable the work to evenly undergo a selenization reaction, and holding the metallic precursor film at a certain temperature for a certain time period to thereby form a selenide-based CIS light absorption layer.

4. The method for forming the light absorption layer of a CIS type thin-film solar cell according to claim 1, 2, or 3, wherein the selenization step comprises disposing the work in an apparatus, replacing the atmosphere in the apparatus with an inert gas, e.g., nitrogen gas, subsequently introducing at ordinary temperature a selenium source, e.g., hydrogen selenide gas, diluted to a concentration in the range of 1-20%, desirably 2-10%, homogenizing the gas atmosphere which tends to separate into an upper part and a lower part within the apparatus due to a difference in specific gravity between the gases by the device for atmosphere homogenization and manner of work disposition described in claim 1 or 2 while keeping the selenium source in the state of being enclosed, heating the gas atmosphere to 400-550°C, desirably 450-500°C, at 10-100 °C/min, and thereafter holding the work at this temperature for a certain time period, i.e., 10-200 minutes, desirably 30-120 minutes, to thereby form a selenide-based CIS light absorption layer.

5. The method for forming the light absorption layer of a CIS type thin-film solar cell according to claim 1 or 2, wherein the sulfurization step comprises disposing the work in an apparatus, replacing the atmosphere in the apparatus with an inert gas, e.g., nitrogen gas, subsequently introducing at ordinary temperature a sulfur source, e.g., sulfide gas, diluted to a concentration in the range of 1-30%, desirably 2-20%, homogenizing the gas atmosphere which tends to separate into an upper part and a lower part within the apparatus due to a difference in specific gravity between the gases by the device for atmosphere homogenization and manner of work disposition described in claim 1 or 2 while keeping the sulfur source in the state of being enclosed, heating the gas atmosphere to 400-550°C, desirably 450-550°C, at 10-100 °C/min, and thereafter holding the work at this temperature for a certain time period, i.e., 10-200 minutes, desirably 30-120 minutes, to thereby form a sulfide-based CIS light absorption layer.

6. The method for forming the light absorption layer of a CIS type thin-film solar cell according to claim 1 or 2, wherein the selenization/sulfurization step comprises forming the selenide-based CIS light absorption layer described in claim 1, 2, 3, or 4, thereafter replacing the selenium atmosphere enclosed in the apparatus with a sulfur atmosphere, preparing the inside of the apparatus by the device for atmosphere homogenization and manner of work disposition described in claim 1 or 2 to enable a sulfurization reaction to proceed evenly while elevating the temperature in the apparatus and maintaining the sulfur atmosphere, and holding the selenide-based CIS light absorption layer described in claim 1, 2, or 3 at a certain temperature for a certain time period to react the layer with sulfur and thereby form a sulfide/selenide-based CIS light absorption layer.

7. The method for forming the light absorption layer of a CIS type thin-film solar cell according to claim 1, 2, 3, or 4, wherein the selenide-based CIS light absorption layer comprises CuInSe₂, Cu(InGa)Se₂, or CuGaSe₂.

8. The method for forming the light absorption layer of a CIS type thin-film solar cell according to claim 1, 2, or 5, wherein the sulfide-based CIS light absorption layer comprises CuInS₂, Cu(InGa)S₂, or CuGaS₂.

9. The method for forming the light absorption layer of a CIS type thin-film solar cell according to claim 1, 2, or 6, wherein the sulfide/selenide-based CIS light absorption layer comprises CuInSe₂ having CuIn(SSe)₂ or Cu(InGa)(SSe)₂ or CuGa(SSe)₂ or CuIn(SSe)₂ as a surface layer, Cu (InGa) Se₂ having CuIn (SSe)₂ as a surface layer, Cu(InGa)(SSe)2 having CuIn(SSe)₂ as a surface layer, CuGaSe₂ having CuIn(SSe)₂ as a surface layer, CuGaSe₂ having CuIn(SSe)₂ as a surface layer, Cu(InGa)Se₂ having Cu(InGa) (SSe)₂ as a surface layer, CuGaSe₂ having Cu(InGa)(SSe)₂ as a surface layer, Cu(InGa)Se₂ having CuGa(SSe)₂ as a surface layer, or CuGaSe₂ having CuGa(SSe)₂ as a surface layer.
